# EUROPEAN PATENT APPLICATION

(11) **EP 4 567 560 A1**
(43) Date of publication of application: **11.06.2025**
(21) Application number: 24217658.4
(22) Date of filing: 05.12.2024
(51) Int. Cl.: G06F 1/30

(54) **SYSTEMS AND METHODS FOR MITIGATING POWER FLUCTUATIONS**

(30) Priority: 07.12.2023 US 202363607310 P; 24.10.2024 US 202418925259
(71) Applicant: Google LLC, Mountain View, CA 94043 (US)
(72) Inventor: Mobarraz, Maziar, Mountain View, California, 94043 (US); Li, Xiong, Mountain View, California, 94043 (US)
(74) Representative: Betten & Resch

(57) **Abstract**

The technology is generally directed to reducing the impact of power fluctuations caused by workloads. The workloads may be executed by a machine, such as a server within a datacenter. The workloads may be memory and/or processing intensive workloads, such as artificial intelligence (AI) workloads. Such AI workloads have become more frequent with the integration of AI into computer based applications. The power fluctuations may occur at a given frequency, such as every "N" seconds. The power fluctuations may be smoothed by increasing the rise and/or fall time of the fluctuation and/or by reducing the magnitude of the fluctuation. Smoothing the fluctuations may be done by an energy supply injecting power into and/or absorbing power from the power system of the rack.

## Description

### CROSS REFERENCE TO RELATED APPLICATIONS

This application claims the benefit of the filing dates of United States Provisional Patent Application No. 63/607,310 filed December 7, 2023 and US Appl. No. 18/925,259 filed October 24, 2024, the disclosure of which is hereby incorporated herein by reference.

### BACKGROUND

When a machine is executing a workload, the machine typically requires an increase in power to run the machine to execute the workload. The power drawn by the machine typically decreases after the job workload is executed. This increase in power and subsequent reduction in power required by the machine tends to result in power fluctuations. When the machine is within a data center, the power fluctuations can have negative impacts at the infrastructure and utility levels. The high rate of power fluctuation can cause voltage and frequency deviations, which can impact both the source of the power as well as other customers the power supplier is supplying. At the infrastructure level, power fluctuations can exceed the capacity of the backup power supplies, thereby causing an overload while additional generators are turned on during a power outage. The power fluctuations caused by the workloads can result in varying temperatures of the components within the machine and/or data center. The varying thermal conditions imposed by the workloads can lead to thermal stress on components within the machines and/or datacenter, such as power semiconductors and bulk capacitors. Thermal stress can reduce the lifetime of the components.

### BRIEF SUMMARY

The technology is generally directed to reducing the impact of power fluctuations caused by workloads. The workloads may be executed by a machine, such as a server within a datacenter. The workloads may be memory and/or processing intensive workloads, such as artificial intelligence (AI) workloads. Such AI workloads have become more frequent with the integration of AI into computer based applications. The power fluctuations may occur at a given frequency, such as every "N" seconds. The power fluctuations may be smoothed by increasing the rise and/or fall time of the fluctuation and/or by reducing the magnitude of the fluctuation. Smoothing the fluctuations may be done by an energy supply injecting power into and/or absorbing power from the power system of the rack.

One aspect of the disclosure is directed to a system, comprising a rack. The rack may comprise a bus and a rack management device including one or more rack processors. The one or more rack processors may be configured to determine one or more targets associated with power fluctuations. The system may further comprise at least one energy supply in communication with the rack. The at least one energy supply may include one or more energy storage processors. The one or more energy storage processors may be configured to receive, from the rack management device, the one or more targets, detect a voltage of the bus, determine, based on the detected voltage, a rack power usage, and smooth, based on the rack power usage and the one or more targets, the power fluctuations.

The one or more targets associated with the power fluctuations may include at least one of a rise time of the power fluctuations, a fall time of the power fluctuations, or a magnitude of the power fluctuations. When the one or more targets is the rise time of the power fluctuations, smoothing the power fluctuations may comprise increasing the rise time of the power fluctuations. When the one or more targets is the fall time of the power fluctuations, smoothing the power fluctuations may comprise increasing the rise time of the power fluctuations. When the one or more targets is the magnitude of the power fluctuations, smoothing the power fluctuations may comprise decreasing the magnitude of the power fluctuations.

When smoothing the power fluctuations the one or more energy storage processors may be further configured to cause the at least one energy supply to inject or absorb power. When a voltage associated with the rack power usage is less than a first setpoint, the at least one energy supply may absorb the power. When the voltage associated with the rack power usage is greater than a second setpoint, the at least one energy supply may inject power.

The rack may further comprise one or more rectifiers. The rack power usage may comprise a total amount of power from a power supply and the one or more rectifiers. The detected voltage may be further based on a droop line of the one or more rectifiers. The droop line may correspond to a change in voltage as the rack drives a load.

Another aspect of the disclosure is directed to a method, comprising receiving, by one or more processors, one or more targets associated with power fluctuations, detecting, by the one or more processors, a voltage of a bus of a rack, determining, by the one or more processors based on the detected voltage, a power usage of the rack, and smoothing, by the one or more processors based on the power usage and the one or more targets, the power fluctuations of the rack.

The one or more targets associated with the power fluctuations may include at least one of a rise time of the power fluctuations, a fall time of the power fluctuations, or a magnitude of the power fluctuations. When the one or more targets is the rise time of the power fluctuations, smoothing the power fluctuations may comprise increasing the rise time of the power fluctuations. When the one or more targets is the fall time of the power fluctuations, smoothing the power fluctuations may comprise increasing the rise time of the power fluctuations. When the one or more targets is the magnitude of the power fluctuations, smoothing the power fluctuations may comprise decreasing the magnitude of the power fluctuations.

When smoothing the power fluctuations, the method further comprises injecting power voltage from at least one energy supply to the rack or absorbing power by the at least one energy supply from the rack. The method may further comprise receiving, by the one or more processors, one or more set points and injecting the power from the at least one energy supply to the rack when a voltage associated with the rack power usage is less than a first setpoint or absorbing the power by the at least one energy supply from the rack when the voltage associated with the rack power usage is greater than a second setpoint.

Determining the power usage of the rack may be further based on power provided by one or more rectifiers of the rack. Detecting the voltage may be further based on a droop line of one or more rectifiers of the rack. The droop line may correspond to a change in voltage as the rack drives a load.

Yet another aspect of the disclosure is directed to an energy supply, comprising one or more processors. The one or more processors may be configured to receive, one or more targets associated with power fluctuations, detect a voltage of a bus of a rack, determine, based on the detected voltage, a power usage of the rack, and smooth, based on the power usage and the one or more targets, the power fluctuations of the rack.

The one or more targets associated with the power fluctuations may include at least one of a rise time of the power fluctuations, a fall time of the power fluctuations, or a magnitude of the power fluctuations. The energy supply may be a battery, supercapacitor, or other storage device.

### BRIEF DESCRIPTION OF THE DRAWINGS

Figure 1A is a graphical representation of power smoothing power usage by increasing the rise and fall time of the power fluctuations according to aspects of the disclosure.
Figure 1B is a graphical representation of power smoothing power usage by decreasing the magnitude of the change in power usage of the power fluctuations according to aspects of the disclosure.
Figure 2A is a graphical representation of a voltage droop according to aspects of the disclosure.
Figure 2B is a graphical representation of when an energy supply injects or absorbs power according to aspects of the disclosure.
Figure 3A is a perspective view of a rack according to aspects of the disclosure.
Figure 3B is another perspective view of the rack of Figure 3A according to aspects of the disclosure.
Figure 4 is a schematic diagram of an example power architecture according to aspects of the disclosure.
Figure 5 is a block diagram of an example system according to aspects of the disclosure.
Figure 6 is a flow diagram of an example method for smoothing power fluctuations according to aspects of the disclosure.

### DETAILED DESCRIPTION

The technology is generally directed to reducing the impact of power fluctuations caused by workloads. The workloads may be executed by a machine, such as a server within a datacenter. The machine may be, in some examples, a payload. The workloads may be memory and/or processing intensive workloads, such as artificial intelligence (AI) workloads. Such AI workloads have become more frequent with the integration of AI into computer software and computer based applications. The power fluctuations may occur at a given frequency, such as every "N" seconds, such that the power fluctuations are substantially predictable. The power fluctuation may be, for example, a rapid increase in power usage, a period of sustained power usage at the increased amount, and a rapid decrease in power usage. The power usage may, in some examples, correspond to a load. The power fluctuations can have negative impacts on the infrastructure of the machine, the infrastructure of the datacenter, and/or the power service provider.

To mitigate the effects of the power fluctuations, the power fluctuations may be smoothed. Smoothing the power fluctuations may include, for example, increasing the rise and fall time of the power fluctuations and/or reducing the magnitude of the power fluctuations. According to some examples, the power fluctuations may be smoothed by an energy supply injecting power into the system and/or absorbing power from the system. The energy supply may be a power source capable of being charged and discharged. For example, the energy supply may be a super capacitor, battery, or the like. By injecting and/or absorbing power, the energy supply may maintain the load of the system within target load levels. In some examples, injecting and/or absorbing power may increase the amount of rise and/or fall time of the power fluctuation. In another example, injecting and/or absorbing power may decrease the magnitude of the power fluctuation.

Increasing the rise time of the power fluctuations may include, for example, extending the amount of time it takes for the load to reach the increased power level. Increasing the fall time of the power fluctuations may include extending the amount of time it takes for the power usage to return to the baseline level from the increased level. The load may correspond to the power usage of the system, payload, or the like. In some examples, the load may correspond to the amount of power used to power a payload. Accordingly, power usage and load may be used interchangeably throughout the disclosure.

Increasing the rise and/or fall time of the power fluctuations may allow for the power usage level to stay within the utility thresholds. The utility thresholds may vary from one utility service provider to another. As one example, the utility threshold may include a voltage magnitude and a frequency. The voltage magnitude may be, for example, over 110% of the power usage threshold and/or under the power usage threshold for a predetermined period of time. For example, the voltage magnitude may be 70% for more than 1 second, 90% more than 4 seconds, or the like. The frequency threshold may be, for example, over 60.6Hz or under 59.4Hz for more than one second. In some examples, increasing the rise and/or fall time of the power fluctuations may allow for the voltage and/or frequency deviations to be maintained within the utility thresholds. According to some examples, the increase in rise time of the fluctuations may allow for backup power supplies, such as generators, to be brought online without overloading the existing backup power supplies.

Reducing the magnitude of the power fluctuations may include, for example, reducing the magnitude of the change of power usage. For example, without power smoothing, the magnitude of the change in power usage may be P1. However, with power smoothing, the magnitude of the change in power usage may be P2. In this example, P2 is less than P1.

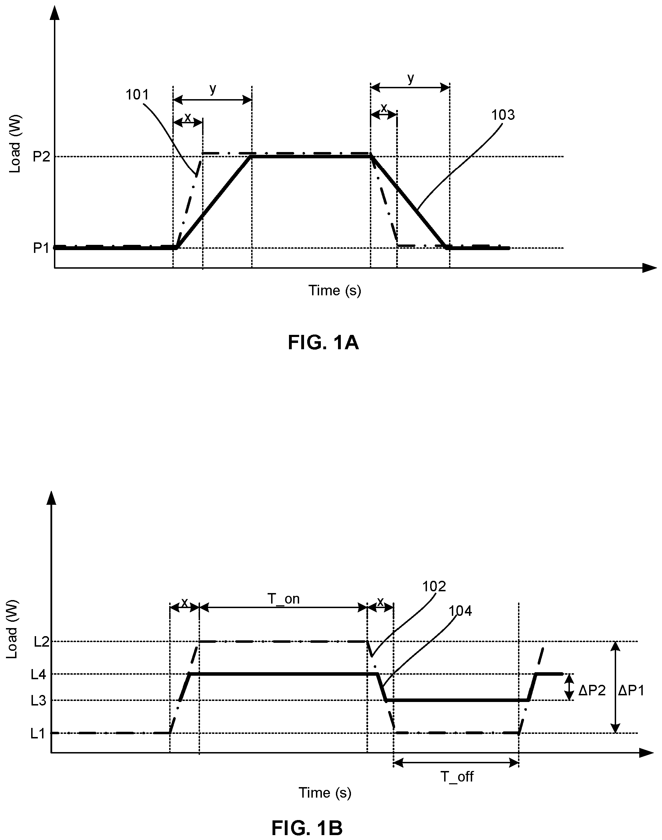

Figure 1A graphically illustrates an example of power smoothing power fluctuations by increasing the rise and fall time of the fluctuation. The power usage, or load, may be the power usage of a payload within a system. In some examples, the power usage may be the power usage of the system. For example, if the system is a datacenter, the power usage may be the power usage of a payload.

The load may initially be at a level "P1." As a workload is scheduled and executed by a machine, the load may increase to level "P2." The workload may be a workload that is memory and/or processing intensive, thereby causing an increase in the load. The more memory and/or processing intensive the workload is, the greater the difference between level P1 and P2 may be. Without power smoothing, represented by line 101, the rise time from level P1 to level P2 may be "x." However, with power smoothing, represented by line 103, the rise time from level P1 to level P2 is "y." Similarly, without power smoothing the fall time from level P2 to level P1 may be "x" while the fall time, with power smoothing, is "y." Increasing the rise and fall time of the power fluctuation may decrease the amount of time the power fluctuation remains at the maximum load, e.g., level P2.

Increasing the rise and fall time of the power fluctuations may mitigate any damage to the infrastructure of the machine executing the workload and/or the datacenter housing the machine. For example, by increasing the rise and fall time of the power fluctuations, the infrastructure of the machines may have additional time to adjust to the thermal variance caused by the increased load. The additional time to adjust to the thermal variance may mitigate any thermal stress, thereby reducing any negative effects on the lifespan of the components. According to some examples, in the case of a power event, such as a blackout, increasing the rise time of the power fluctuations may provide for additional time for backup power supplies to come online. The additional time for backup power supplies, such as generators, to come online may prevent the existing power supplies from being overloaded.

According to some examples, the load step change may have a predetermined, or particular, rise and/or fall time. An external energy supply may be configured to be a power source when the load is increasing and/or when there is a load reduction. By adjusting the share of power provided by the energy supply and/or the rate at which power is provided by the energy supply, the rise and/or fall time of the power fluctuation may be adjusted.

Figure 1B graphically illustrates an example of power smoothing power fluctuations by decreasing the magnitude of power fluctuations. The load may be the power usage of a payload within the system. For example, the load may be the power usage of a payload of a rack within a datacenter. A representation 102 of a load without power smoothing is illustrated as is a representation 104 of a load with power smoothing.

The load may initially be at a level "L1." As a workload is scheduled and executed by a payload, the load may increase to level "L2." The magnitude of the power fluctuation from when there is no load, e.g., level L1, and when there is a full load, e.g., level L2, is ΔP1. However, with power smoothing, the magnitude of the power fluctuation may be reduced from ΔP1 to ΔP2. For example, the energy supply may inject power into the rack as a load is applied such that the load on the power system of the rack reaches level "L4", rather than level "L2." When the load is no longer applied to the power system of the rack, the energy supply may absorb power such that the load returns to level "L3" instead of "L1.".]

The energy supply injecting and absorbing power based on the load reduces the magnitude of the power fluctuations. Reducing the magnitude of power fluctuations mitigates any negative effects on the lifespan of components within the payload, rack, datacenter, utility infrastructure, or the like caused by consistent power fluctuations with large swings compared to the baseline load. In some examples, reducing the magnitude of power fluctuations may decrease the need for additional backup power suppliers in the event of a power event. For example, in the case of a power event, such as a blackout, a reduced magnitude in power fluctuations may decrease the amount of backup power supplies needed to continue operating the system without interruption.

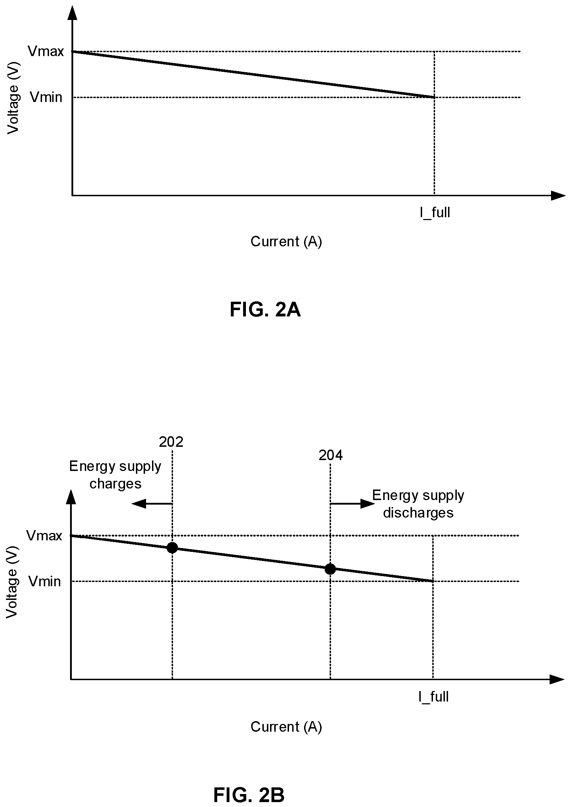

Figure 2A graphically illustrates an example voltage droop. According to some examples, the rack may include one or more rectifiers. The rectifiers may utilize voltage droop control for dynamic current sharing. The voltage droop may, in some examples, be the loss in output voltage of the rectifiers as the rack drives a load. According to some examples, the static current sharing mechanism may be based on a primary rectifier of the rack broadcasting its current and the secondary rectifiers in the rack adjusting their voltage to make their current the same as their primary. For example, as shown in Figure 2, without the voltage droop the voltage may be at a maximum "Vmax." The maximum voltage may be, for example, the voltage of the system when there is no load. With the voltage droop, the voltage may be at a minimum voltage "Vmin." The minimum voltage may be, for example, the voltage of the system when there is a full load.

According to some examples, an energy supply may determine the load of the rack. According to some examples, the load may correspond to the power consumption of the payloads. The energy supply may be an external energy supply, or power source. For example, the energy supply may be separate and distinct from the power system of the rack. In some examples, the energy supply may be separate from the power supplier, e.g., the electrical grid, supplying power to the datacenter. In some examples, the load may be based on the droop line of the rectifier.

The energy supply may be in communication with the rack, such as via the main bus and/or a network. The load may be determined based on the voltage of the main bus bar of the rack and/or the droop line of the rectifiers within the rack. For example, the energy supply may detect the voltage of the main bus bar. Based on the detected voltage and/or the droop line of the rectifier, the energy supply may determine the load of the rack. According to some examples, based on the determined power usage of the rack, the energy supply may inject or absorb power . For example, the energy supply may receive one or more setpoints from the rack. The set points may be determined based on the current and/or upcoming workload, the targets for the rise and/or fall times, and/or the magnitude of the power fluctuation. The setpoints may, in some examples, vary based on the jobs to be served, the power supply, or the like.

Figure 2B illustrates example set points. The set points may be used to determine when to absorb power and/or when to inject power. Absorbing power may allow for the energy supplies to charge without causing the power usage of the system to exceed its thresholds or targets. Injecting power may allow for the power usage of the system to stay within its thresholds, or targets. In some examples, the energy supply absorbing and/or injecting power may smooth the power fluctuations. For example, by absorbing and/or injecting power into the system, the rise and/or fall time of the power fluctuation may increase. The rise and/or fall time of the power fluctuation may be increased by adjusting the share of power provided by the energy supply and/or the rate at which power is provided by the energy supply. In some examples, by absorbing and/or injecting power into the system, the magnitude of the power fluctuations may decrease as the absorption and/or injection of voltage can maintain the power of the system within target limits. The target limits may be, in some examples, predetermined by the utility service provider.

The absorption and/or injection of power may be determined based on the setpoints. For example, when the energy supply determines that the power and/or current associated with the power usage is less than setpoint 202, the energy supply may absorb power such that the energy supply is charged. The energy supply may absorb power from the power system of the rack. In some examples, by absorbing power from the power system of the rack, the energy supply may be charged. According to some examples, when the energy supply determines that the power and/or current associated with the power usage is greater than setpoint 204, the energy supply may inject power such that the energy supply is discharged. The energy supply may inject power into the power system of the rack. By injecting the power into the power system of the rack, the amount of power drawn from the rectifiers, battery backups, the grid, or the like may be reduced.

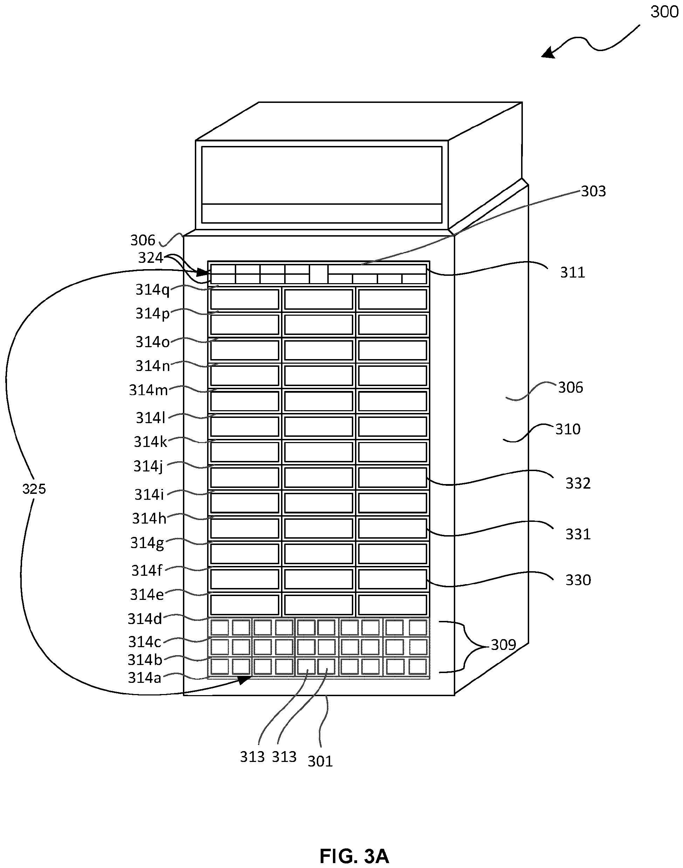

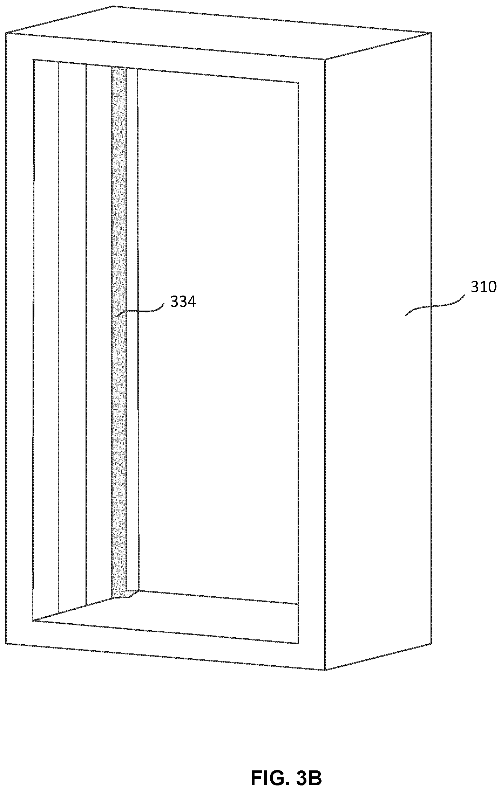

Figures 3A and 3B are examples of a server system. Figure 3A depicts a server system 300 that may include a data center rack 310 having a floor 301, a ceiling 303, sidewalls 306, a plurality of shelves 314a-314q for holding payloads, a rack monitoring unit (RMU) 311 for monitoring the status of the features to the rack, a plurality of payloads 330-332, and a power system 325 including a plurality of rectifiers 324 and a battery backup 309, including battery units 313.

In one example, payload 330 may be a dedicated storage device, for example, including any type of memory capable of storing information accessible by a processor, such as a hard-drive, memory card, ROM, RAM, DVD, CD-ROM, or solid state memory. In another example, payload 331 may be a preprogrammed load which draws power from the main bus bar in order to test the operation of the system 300. According to some examples, one or more payloads 330-332 may be servers or trays. Additionally or alternatively, payloads 330-332 may be any device that generates a load. In some examples, payloads 330-332 may be any device that consumes power.

Figure 3B is an example of rack 310 without shelves 314a-314q. In this figure, it can be seen that the rack 310 includes a main bus bar 334. The main bus bar 334 may be connected to each shelf 314a-314q of the rack 310 to provide power and data to the payloads.

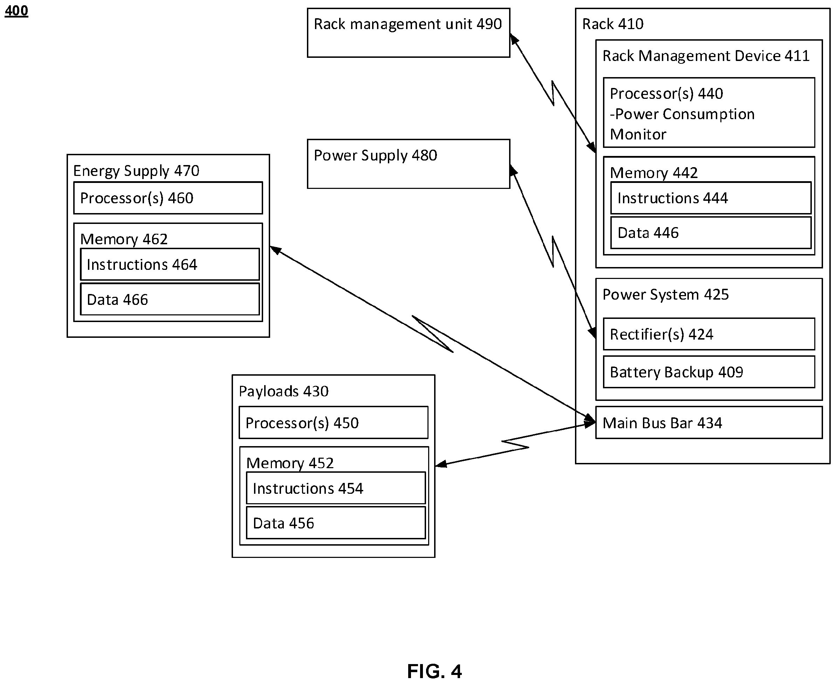

Figure 4 illustrates an example system 400 in which the features described above and herein may be implemented. While a number of components are shown, such components are merely non-limiting examples and other components may additionally or alternatively be included. The figures should not be considered limiting the scope of the disclosure or usefulness of the features described herein. In this example, system 400 may include a rack 410, payload(s) 430, energy supply 470, power supply 480, and rack management unit 490.

Energy supply may be, for example, an external energy or power supply. The energy supply 470 may be configured to charge and discharge, such as by absorbing or injecting power from or into another device. In some examples, the energy supply 470 may be a supercapacitor, battery, the like. Power supply 480 may be, for example, a power supply infrastructure, such as a power grid.

Rack management unit 490 may, in some examples, be a program or application configured to manage rack power system components. The rack management unit 490 may be configured to communicate with rack 410 via a network, a communications interface, or the like. According to some examples, the rack management unit 490 may communicate with the rack management device 411. The rack management device 411 may be configured to function as a gateway between the rack management unit 490 and the power system 425.

The rack management unit 490 and/or the rack management device 411 may be configured to set the power control targets for the energy supply 470 based on the workload profile. The power control targets may, in some examples, be the minimum and maximum thresholds for power usage of the rack 410. In some examples, the power control targets may correspond to the set points for determining when the energy supply 470 should inject and/or absorb power. The workload profile may, in some examples, be determined by the rack management unit 490, the rack management device 411, machine managers, or the like.

The rack management device 411 may transmit the power control targets, the target rise and/or fall time of the power fluctuations, and/or the magnitude of the power fluctuation to the energy supply 470. Based on the power control targets, the target rise and/or fall time of the power fluctuations, and/or the magnitude of the power fluctuation, the energy supply 470 may smooth the power fluctuations.

The rack 410 may include the rack management device 411, power system 425, and main bus bar 434. The rack management device 411 may include one or more processors 440, memory 442, instructions 444, and data 446.

The processors 440 may be any conventional processors, such as commercially available microprocessors. Alternatively, the one or more processors may be an application specific integrated circuit (ASIC) or other hardware-based processor. Although Figure 4 functionally illustrates the processor, memory, and other elements of rack 410 as being within the same block, it will be understood by those of ordinary skill in the art that the processor, computing device, or memory may actually include multiple processors, computing devices, or memories that may or may not be stored within the same physical housing. Similarly, the memory may be a hard drive or other storage media located in a housing different from that of rack 410. Accordingly, references to a processor or computing device will be understood to include references to a collection of processors or computing devices or memories that may or may not operate in parallel.

Memory 442 may store information that is accessible by the processors, including instructions 444 that may be executed by the processors 440. The memory 442 may be a type of memory operative to store information accessible by the processors 440, including a non-transitory computer-readable medium, or other medium that stores data that may be read with the aid of an electronic device, such as a hard-drive, memory card, read-only memory ("ROM"), random access memory ("RAM"), optical disks, as well as other write-capable and read-only memories. The subject matter disclosed herein may include different combinations of the foregoing, whereby different portions of the instructions 444 and data 446 are stored on different types of media.

Memory 442 may be retrieved, stored or modified by processors 440 in accordance with the instructions 444. For instance, although the present disclosure is not limited by a particular data structure, the data 446 may be stored in computer registers, in a relational database as a table having a plurality of different fields and records, XML documents, or flat files. The data 446 may also be formatted in a computer-readable format such as, but not limited to, binary values, ASCII or Unicode. By further way of example only, the data 446 may be stored as bitmaps comprised of pixels that are stored in compressed or uncompressed, or various image formats (e.g., JPEG), vector-based formats (e.g., SVG) or computer instructions for drawing graphics. Moreover, the data 446 may comprise information sufficient to identify the relevant information, such as numbers, descriptive text, proprietary codes, pointers, references to data stored in other memories (including other network locations) or information that is used by a function to calculate the relevant data.

The instructions 444 can be any set of instructions to be executed directly, such as machine code, or indirectly, such as scripts, by the processor 440. In that regard, the terms "instructions," "application," "steps," and "programs" can be used interchangeably herein. The instructions can be stored in object code format for direct processing by the processor, or in any other computing device language including scripts or collections of independent source code modules that are interpreted on demand or compiled in advance. Functions, methods and routines of the instructions are explained in more detail below.

The processors 440 may include a power consumption monitor that monitors the power consumption of the one or more payloads 430. The power consumption monitor may, in some examples, detect the amount of power being drawn by the rectifiers 424. According to some examples, the rack management device 411 may transmit information regarding the amount of power being drawn by the rectifiers to the energy supply 470.

According to some examples, the processors 440 of the rack 410 may be configured to determine one or more targets associated with power fluctuations. The power fluctuations may be substantially cyclical, such that the power fluctuations occur with a given frequency. To mitigate any negative effects associated with the power fluctuations, such as damage to the infrastructure or impacts to those being served by power supply 480, the processors 440 may determine one or more targets for smoothing the power fluctuations. The targets may be, for example, an amount of time to increase the rise and/or fall time of the power fluctuations, an amount to reduce the magnitude of the power fluctuations, or the like. The processors 440 may determine the targets based on the workload received from the rack management unit 490, the power supply 480, etc.

Power system 425 may include one or more rectifiers 424 and battery backup 409. The rectifiers 424 may be connected to the main bus bar 434 and supply voltage and, therefore, power to the payloads 430. The battery backup 409 may include on or more battery units, such as battery units 313. The battery backup 409 may provide power in the case of a power event, such as a power outage.

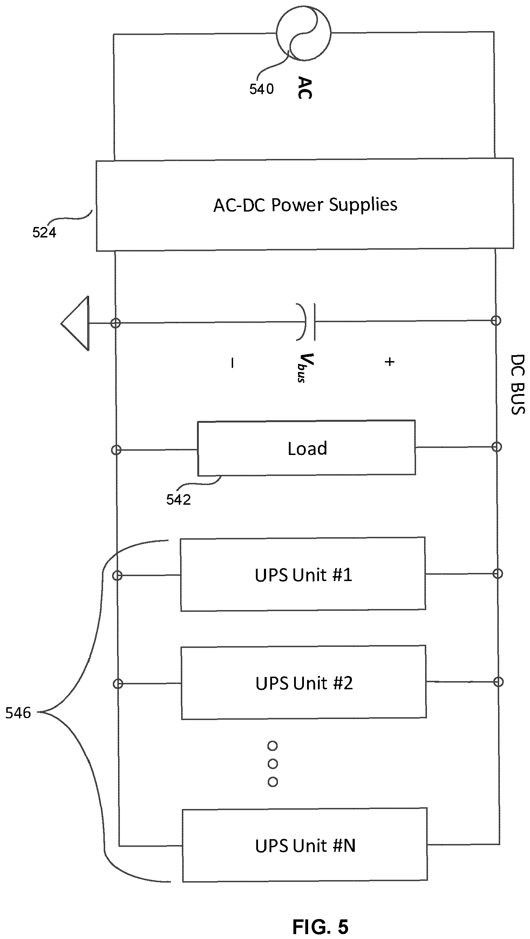

Figure 5 is an example of a power architecture for power system 425. An AC power source 540 may be connected to the rectifiers 424. In this example, the rectifiers 424 may be AC to DC rectifiers 524, as shown in Figure 5. The rectifiers 524 may be connected to the main bus bar 334 and supply power to a payload, such as payloads 330-332 shown in Figure 3A. The load 542 may be connected in parallel to a plurality of uninterruptible power supply units (UPS) 546. The UPSs 546 may correspond to the battery units 313 disposed on shelves 314a-314c, shown in Figure 3A. According to some examples, UPSs 546 may make up the battery backup supply 309, 409.

Returning to Figure 4, the main bus bar 434 may provide power and data from the rack 410 to the payloads 430. Additionally or alternatively, the main bus bar 434 may provide data from the payloads 430 to the rack 410.

Payloads 430 may include one or more processors 450, memory 452, instructions 454, and data 456 that are substantially similar to those described herein with respect to rack 410.

According to some examples, the main bus bar 434 may provide power and data from the rack 410 to energy supply 470. According to some examples, energy supply 470 and rack 410 may communicate via a network, communications interface, or the like to exchange data, such as the targets. Energy supply 470 may include one or more processors 460, memory 462, instructions 464, and data 466 that are substantially similar to those described herein with respect to rack 410.

The processors 460 of energy supply 470 may be configured to detect a voltage of the main bus bar 434. According to some examples, the processors 460 may determine, based on the detected voltage, the rack 410 power usage. In some examples, the rack 410 power usage may be further based on the droop line of the rectifiers 424. Based on the rack 410 power usage, the processors 460 may smooth the power fluctuations associated with the rack 410 power usage. For example, based on the targets received from the rack management device 411, the energy supply 470 may smooth the power fluctuations such that the power usage of the rack 410 stays within a minimum and maximum power usage. The minimum and maximum power usage may be based on the power supply 480, infrastructure of the rack 410 and/or data center, or the like. According to some examples, smoothing the power fluctuations may include injecting power from the energy supply 470 to the power system 425 of rack 410 via main bus bar 434. In some examples, smoothing the power fluctuations may cause the energy supply 470 absorbing power from the power system 435 of rack 410 via main bus bar 434. By absorbing and/or injecting power, the energy supply 470 may increase the rise and/or fall time of the power fluctuation and/or decrease the magnitude of the power fluctuation, thereby smoothing the power fluctuation.

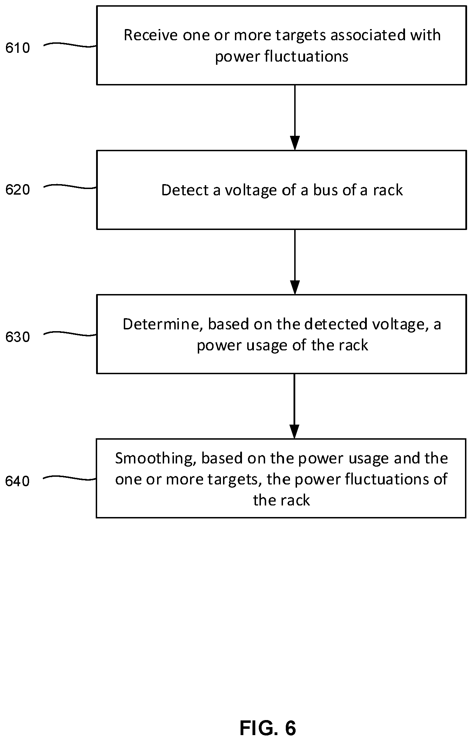

Figure 6 illustrates an example method for smooth power fluctuations. The following operations do not have to be performed in the precise order described below. Rather, various operations can be handled in a different order or simultaneously, and operations may be added or omitted.

In block 610, one or more targets associated with power fluctuations may be received. The one or more targets may be received by an energy supply capable of injecting power (e.g., discharging) and absorbing power (e.g., charging). The energy supply may be, for example, a supercapacitor, battery, or the like. The energy supply may receive the one or more targets from a separate device. For example, the energy supply may receive the one or more targets from a rack within a datacenter.

The one or more targets associated with the power fluctuations may include at least one of a rise time of the power fluctuations, a fall time of the power fluctuations, or a magnitude of the power fluctuations.

According to some examples, one or more set points may be received in addition to the one or more targets. The set points may identify voltage and/or current levels associated with the power usage, or load. The identified voltage and/or current levels may provide an indication as to when the energy supply should inject power into the power system of the rack (e.g., discharge) or absorb power from the power system of the rack (e.g., charge).

In block 620, a voltage of a bus of the rack may be detected. For example, the energy supply may be in communication with the bus, e.g., main bus bar 434, of the rack. The energy supply may detect the voltage of the bus. In some examples, the detected voltage may be based on a droop line of one or more rectifiers of the rack. The droop line may be, for example, a change in voltage of the rectifiers as the rectifiers drive a load. In some examples, the droop line may be the loss in voltage of the rectifiers as the rectifiers drive a load.

In block 630, a power usage of the rack may be determined based on the detected voltage. The power usage of the rack may, in some examples, correspond to the load of one or more payloads in communication with the rack. According to some examples, the power usage may be further based on power provided by one or more rectifiers of the rack. For example, the load, or power usage, may be determined based on the power supplied to the payload from the rectifiers.

In block 640, the power fluctuations of the rack may be smooth based on the power usage and the one or more targets. In some examples, when the one or more targets is the rise time of the power fluctuations, smoothing the power fluctuations may include increasing the rise time of the power fluctuations. In another example, the one or more targets is the fall time of the power fluctuations, smoothing the power fluctuations may include increasing the rise time of the power fluctuations. Increasing the rise and/or fall time of the power fluctuations may include increasing the amount of time the load increases from a power usage level with no load to the power usage level with a full load. The time may be increased as compared to when no power smoothing is applied.

In yet another example, when the one or more targets is the magnitude of the power fluctuations, smoothing the power fluctuations may include decreasing the magnitude of the power fluctuations. Decreasing the magnitude of the power fluctuations may include reducing the difference between the maximum power usage at a full load to the minimum power usage at substantially no load. The reduced difference between the maximum and minimum power usage may be reduced as compared to when no power smoothing is applied.

According to some examples, the rise and/or fall time is increased and/or the magnitude of the power fluctuation is decreased by injecting power from at least one energy supply to the rack and/or absorbing power by the at least one energy supply from the rack. In some examples, the at least one power supply may inject power into the power system of the rack and/or absorb power from the power system of the rack. By injecting and/or absorbing power, the power system of the rack, e.g., the rectifiers, may draw less power from the grid, thereby reducing the power fluctuations.

The power may be injected from the energy supply to the rack when the voltage associated with the rack power usage is less than the first set point. For example, when the voltage is less than the determined setpoint, the energy supply may discharge, thereby injecting the power system of the rack with power. In some examples, the energy supply may absorb power from the rack when a voltage associated with the rack power usage is greater than a second set point. For example, when the voltage is greater than the determined setpoint, the energy supply may absorb power from the power system of the rack, thereby charging the energy supply.

The power fluctuations may be caused by memory and/or processing intensive workloads, such as AI workloads. The AI workloads may be, in some examples, machine learning, large language model (LLM), or other AI workloads that require an increase in memory and processing power, which causes an increased load on the system. The load swings caused by the AI workloads have increased as the integration of AI into applications and software continue to increase. The load swings can occur frequently and continuously.

By having the energy supply in communications with the rack, the communication between the components within the system is simplified. For example, by having the energy supply in communication with the rack via the main bus bar, the energy supply is in communication with the electrical grid via the rack. This reduces the need for the energy supply to be in communication with multiple components. Further, this reduces and/or mitigates the latencies in communication between additional components in the system. According to some examples, the communication between the energy supply and the rack allows for the power fluctuations to be smoothed in real-time, thereby mitigating any negative effects of the power fluctuations. The power fluctuations can be smoothed in real time based on the real-time power line communication, e.g., the droop line of the rectifiers, without having the communication between components being held up.

Smoothing the power fluctuations, such as by increasing the rise and/or fall time of the power fluctuation and/or decreasing the magnitude of the power fluctuation, may mitigate any negative impacts the power fluctuation may have on the infrastructure of the payload, the infrastructure of the rack, the infrastructure of the datacenter, the power service provider, and/or consumers of the power service provider. For example, by smoothing the power fluctuations, the power usage level may be maintained within utility thresholds. In some examples, by smoothing the power usage level, such as by increasing the rise and/or fall time of the power fluctuations, may allow for backup power supplies, such as generators, to be brought online without overloading the existing backup power supplies. Increasing the rise and/or fall time of the power fluctuations may allow for the components to have additional time to adjust to the thermal variance caused by the increased load. The additional time to adjust to the thermal variance may mitigate any thermal stress, thereby reducing any negative effects on the lifespan of the components.

Aspects of this disclosure can be implemented in digital electronic circuitry, in tangibly-embodied computer software or firmware, and/or in computer hardware, such as the structure disclosed herein, their structural equivalents, or combinations thereof. Aspects of this disclosure can further be implemented as one or more computer programs, such as one or more modules of computer program instructions encoded on a tangible non-transitory computer storage medium for execution by, or to control the operation of, one or more data processing apparatus. The computer storage medium can be a machine-readable storage device, a machine-readable storage substrate, a random or serial access memory device, or combinations thereof. The computer program instructions can be encoded on an artificially generated propagated signal, such as a machine-generated electrical, optical, or electromagnetic signal, that is generated to encode information for transmission to suitable receiver apparatus for execution by a data processing apparatus.

The term "configured" is used herein in connection with systems and computer program components. For a system of one or more computers to be configured to perform particular operations or actions means that the system has installed on it software, firmware, hardware, or a combination thereof that cause the system to perform the operations or actions. For one or more computer programs to be configured to perform particular operations or actions means that the one or more programs include instructions that, when executed by one or more data processing apparatus, cause the apparatus to perform the operations or actions.

The term "data processing apparatus" refers to data processing hardware and encompasses various apparatus, devices, and machines for processing data, including programmable processors, a computer, or combinations thereof. The data processing apparatus can include special purpose logic circuitry, such as a field programmable gate array (FPGA) or an application specific integrated circuit (ASIC). The data processing apparatus can include code that creates an execution environment for computer programs, such as code that constitutes processor firmware, a protocol stack, a database management system, an operating system, or combinations thereof.

The data processing apparatus can include special-purpose hardware accelerator units for implementing machine learning models to process common and compute-intensive parts of machine learning training or production, such as inference or workloads. Machine learning models can be implemented and deployed using one or more machine learning frameworks.

The term "computer program" refers to a program, software, a software application, an app, a module, a software module, a script, or code. The computer program can be written in any form of programming language, including compiled, interpreted, declarative, or procedural languages, or combinations thereof. The computer program can be deployed in any form, including as a stand alone program or as a module, component, subroutine, or other unit suitable for use in a computing environment. The computer program can correspond to a file in a file system and can be stored in a portion of a file that holds other programs or data, such as one or more scripts stored in a markup language document, in a single file dedicated to the program in question, or in multiple coordinated files, such as files that store one or more modules, sub programs, or portions of code. The computer program can be executed on one computer or on multiple computers that are located at one site or distributed across multiple sites and interconnected by a data communication network.

The term "database" refers to any collection of data. The data can be unstructured or structured in any manner. The data can be stored on one or more storage devices in one or more locations. For example, an index database can include multiple collections of data, each of which may be organized and accessed differently.

The term "engine" refers to a software-based system, subsystem, or process that is programmed to perform one or more specific functions. The engine can be implemented as one or more software modules or components, or can be installed on one or more computers in one or more locations. A particular engine can have one or more computers dedicated thereto, or multiple engines can be installed and running on the same computer or computers.

The processes and logic flows described herein can be performed by one or more computers executing one or more computer programs to perform functions by operating on input data and generating output data. The processes and logic flows can also be performed by special purpose logic circuitry, or by a combination of special purpose logic circuitry and one or more computers.

A computer or special purposes logic circuitry executing the one or more computer programs can include a central processing unit, including general or special purpose microprocessors, for performing or executing instructions and one or more memory devices for storing the instructions and data. The central processing unit can receive instructions and data from the one or more memory devices, such as read only memory, random access memory, or combinations thereof, and can perform or execute the instructions. The computer or special purpose logic circuitry can also include, or be operatively coupled to, one or more storage devices for storing data, such as magnetic, magneto optical disks, or optical disks, for receiving data from or transferring data to. The computer or special purpose logic circuitry can be embedded in another device, such as a mobile phone, a personal digital assistant (PDA), a mobile audio or video player, a game console, a Global Positioning System (GPS), or a portable storage device, e.g., a universal serial bus (USB) flash drive, as examples.

Computer readable media suitable for storing the one or more computer programs can include any form of volatile or non-volatile memory, media, or memory devices. Examples include semiconductor memory devices, e.g., EPROM, EEPROM, or flash memory devices, magnetic disks, e.g., internal hard disks or removable disks, magneto optical disks, CD-ROM disks, DVD-ROM disks, or combinations thereof.

Aspects of the disclosure can be implemented in a computing system that includes a back end component, e.g., as a data server, a middleware component, e.g., an application server, or a front end component, e.g., a client computer having a graphical user interface, a web browser, or an app, or any combination thereof. The components of the system can be interconnected by any form or medium of digital data communication, such as a communication network. Examples of communication networks include a local area network (LAN) and a wide area network (WAN), e.g., the Internet.

The computing system can include clients and servers. A client and server can be remote from each other and interact through a communication network. The relationship of client and server arises by virtue of the computer programs running on the respective computers and having a client-server relationship to each other. For example, a server can transmit data, e.g., an HTML page, to a client device, e.g., for purposes of displaying data to and receiving user input from a user interacting with the client device. Data generated at the client device, e.g., a result of the user interaction, can be received at the server from the client device.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A system, comprising:
a rack comprising:
a bus; and
a rack management device including one or more rack processors, the one or more rack processors configured to determine one or more targets associated with power fluctuations; and
at least one energy supply in communication with the rack, the at least one energy supply including one or more energy storage processors, the one or more energy storage processors configured to:
receive, from the rack management device, the one or more targets;
detect a voltage of the bus;
determine, based on the detected voltage, a rack power usage; and
smooth, based on the rack power usage and the one or more targets, the power fluctuations.

2. The system of claim 1, wherein the one or more targets associated with the power fluctuations includes at least one of a rise time of the power fluctuations, a fall time of the power fluctuations, or a magnitude of the power fluctuations.

3. The system of claim 2, wherein:
when the one or more targets is the rise time of the power fluctuations, smoothing the power fluctuations comprises increasing the rise time of the power fluctuations,
when the one or more targets is the fall time of the power fluctuations, smoothing the power fluctuations comprises increasing the rise time of the power fluctuations, or
when the one or more targets is the magnitude of the power fluctuations, smoothing the power fluctuations comprises decreasing the magnitude of the power fluctuations.

4. The system of one of claims 1 to 3, wherein when smoothing the power fluctuations the one or more energy storage processors are further configured to cause the at least one energy supply to inject or absorb power.

5. The system of claim 4, wherein:
when a voltage associated with the rack power usage is less than a first setpoint, the at least one energy supply absorbs the power; and
when the voltage associated with the rack power usage is greater than a second setpoint, the at least one energy supply injects power.

6. The system of one of claims 1 to 5, wherein the rack further comprises one or more rectifiers.

7. The system of claim 6, wherein the rack power usage comprises a total amount of power from a power supply and the one or more rectifiers; and/or
wherein the detected voltage is further based on a droop line of the one or more rectifiers; and
wherein optionally the droop line corresponds to a change in voltage as the rack drives a load.

8. A method, comprising:
receiving, by one or more processors, one or more targets associated with power fluctuations;
detecting, by the one or more processors, a voltage of a bus of a rack;
determining, by the one or more processors based on the detected voltage, a power usage of the rack; and
smoothing, by the one or more processors based on the power usage and the one or more targets, the power fluctuations of the rack.

9. The method of claim 8, wherein the one or more targets associated with the power fluctuations includes at least one of a rise time of the power fluctuations, a fall time of the power fluctuations, or a magnitude of the power fluctuations.

10. The method of claim 9, wherein:
when the one or more targets is the rise time of the power fluctuations, smoothing the power fluctuations comprises increasing the rise time of the power fluctuations,
when the one or more targets is the fall time of the power fluctuations, smoothing the power fluctuations comprises increasing the rise time of the power fluctuations, or
when the one or more targets is the magnitude of the power fluctuations, smoothing the power fluctuations comprises decreasing the magnitude of the power fluctuations.

11. The method of one of claims 8 to 10, wherein when smoothing the power fluctuations, the method further comprises:
injecting power from at least one energy supply to the rack; or
absorbing power by the at least one energy supply from the rack.

12. The method of claim 11, further comprising:
receiving, by the one or more processors, one or more set points; and
injecting the power from the at least one energy supply to the rack when a voltage associated with the rack power usage is less than a first setpoint; or
absorbing the power by the at least one energy supply from the rack when the voltage associated with the rack power usage is greater than a second setpoint.

13. The method of one of claims 8 to 12, wherein determining the power usage of the rack is further based on power provided by one or more rectifiers of the rack; and/or
wherein detecting the voltage is further based on a droop line of one or more rectifiers of the rack; and
wherein optionally the droop line corresponds to a change in voltage as the rack drives a load.

14. An energy supply, comprising:
one or more processors, the one or more processors configured to:
receive one or more targets associated with power fluctuations;
detect a voltage of a bus of a rack;
determine, based on the detected voltage, a power usage of the rack; and
smooth, based on the power usage and the one or more targets, the power fluctuations of the rack.

15. The energy supply of claim 14, wherein the one or more targets associated with the power fluctuations includes at least one of a rise time of the power fluctuations, a fall time of the power fluctuations, or a magnitude of the power fluctuations; and/or
wherein the energy supply is a battery, supercapacitor, or energy storage device.
